# EUROPEAN PATENT SPECIFICATION

(11) **EP 2 903 024 B1**
(45) Date of publication and mention of the grant of the patent: **03.08.2022**
(21) Application number: 14153405.7
(22) Date of filing: 31.01.2014
(51) Int. Cl.: H01L 25/07, H01L 23/498, H01L 21/48, H01R 4/26, H05K 3/32, H01R 12/57, H05K 3/30

(54) **Contact element, power semiconductor module and method of fabricating same**
Kontaktelement, Leistungshalbleitermodul und Verfahren zu dessen Herstellung
Élément de contact, module semi-conducteur de puissance et son procédé de fabrication

(43) Date of publication of application: 05.08.2015
(73) Proprietor: Vincotech GmbH, 82008 Unterhaching (DE)
(72) Inventor: Geczy, Mihály, 8000 Székesfehérvár (HU); Vigh, Attila, 1025 Budapest (HU)
(74) Representative: Grünecker Patent- und Rechtsanwälte PartG mbB

(56) References cited:
- WO-A1-2013/089211
- WO-A1-2013/168711
- DE-A1-102006 051 454
- DE-B4- 10 008 572
- DE-B4-102004 057 421
- US-A1- 2010 013 086
- US-A1- 2012 106 086
- US-A1- 2014 246 783

## Description

The present invention relates to a contact element for a power semiconductor module having a circuit carrier and at least one power semiconductor element. In particular, the present invention relates to such a power semiconductor module having an improved contact element for contacting an external electronic component. The present invention further relates to a method for fabricating such a power semiconductor module.

Power semiconductors have been extensively used for automotive electronics, energy management and industrial motor and automatization technique. Usually, these power semiconductors are grouped together in power semiconductor modules, which are designed according to the particular application requirements. High-power applications such as automotive, wind, solar, and standard industrial drives require power modules which fulfill the demand for high reliability, thermal, mechanical and electrical ruggedness. These power modules may, for instance, form power conversion circuits, such as AC/DC converters or DC/DC converters.

Because power semiconductors, such as insulated gate bipolar transistors (IGBT), MOSFETs or diodes, generate at least temporarily high temperatures, an effective heat management is essential for power semiconductor modules. A promising approach for achieving fast heat dissipation is the use of direct copper bonding (DCB) circuit carriers, direct aluminum bonding substrates, or insulated metal substrates (IMS), which carry the power semiconductor chips in a surface mount technique. Usually, the power semiconductor chip is electrically connected on the carrier with structured copper or aluminum layers. On the top side (being the surface opposite to the one that is adjacent to the circuit carrier surface), the chip is electrically contacted to a metal lead pattern on the chip carrier by means of wire or ribbon bonding. In particular, the use of ribbon bonding has the advantage of a high current carrying capacity. The circuit carrier comprises an electrically insulating layer formed e. g. from aluminum oxide or aluminum nitride.

US 2010/0013086 A1 describes a power semiconductor device having a cylindrical external terminal communication section arranged perpendicularly on a wiring pattern. An external terminal can be inserted and connected to the cylindrical external terminal communication section to be electrically connected to the wiring pattern. A taper is formed at, at least; one end of the cylindrical external terminal communication section, which one end is joined to the wiring pattern.

US 2012/106086 A1 relates to a semiconductor module having an insert. The power semiconductor module includes a module housing with a sealing ring on its top side. The sealing ring, in co-operation with the module housing and a printed circuit board attached to the power semiconductor module, hermetically seals feed-through locations at the top side of the module housing for feeding through electric terminals of the power semiconductor module. On the bottom side of the module housing a sealing ring hermetically seals the bottom side of the module housing.

WO 2013/168711 A1 describes a power module that is provided with: a substrate on which a semiconductor element is to be mounted; an electrically conductive connection terminal that forms a coil spring shape from spirally wound wire material, and that by making contact with an external circuit, electrically connects the circuit and the substrate; and an electrically conductive holding member that is bonded to the front surface of the substrate, forms a column shape extending in a direction orthogonal to the front surface, and holds the connection terminal. The connection terminal comprises: a close-wind section in which the wire material is closely wound, and in which at least a portion thereof contacts the holding member and is held by the holding member; and a coarse-wind section in which the wire material is wound in a coarser pitch than in the close-wind section.

WO 2013/089211 A1 describes a semiconductor device capable of being productively manufactured, in which an implant substrate and a semiconductor element mounted on a semiconductor mounting substrate are joined and electrically connected through implant pins. In the semiconductor device, an implant pin is joined to a semiconductor element on a semiconductor mounting substrate and/or to a circuit pattern via a cylindrical terminal into which the other end of the implant pin is pressed. In addition, the depth of the implant pin pressed into the cylindrical terminal is adjustable. In this way, the total length of the cylindrical terminal and the implant pin being pressed into the cylindrical terminal is fitted to the distance between the semiconductor element on the semiconductor mounting substrate and an implant substrate and/or to the distance between the circuit pattern and the implant substrate.

DE10 2006 051454 A1 relates to a semiconductor device, which includes a base plate, an insulating substrate on the base plate, and a wiring patterned layer on the insulating substrate. In addition, the semiconductor device includes at least one semiconductor chip bonded on the wiring patterned layer, the semiconductor chip having a surface electrode. A main terminal is connected via a conductive adhesive layer onto at least either one of the surface electrode and the wiring patterned layer. In addition, a resin package covers the insulating substrate, the wiring patterned layer, the semiconductor chip, the conductive adhesive layer, and at least a portion of the main terminal.

In order to create a reliable and rugged electrical as well as mechanical and thermal contact between the chip and the substrate, a silver sinter technology is increasingly used instead of soldering for the connection between the metalized backside of the chip and the circuit carrier surface. For generating a sintered chip/substrate connection, a special silver particle layer is arranged between the two bond parts and by applying a given temperature and pressure to the bond for a given time, a stable sinter connection is produced. The contact strength achieved by the sintered layer between chips and substrates is extraordinarily high and the sintered layers display high load cycling capability, as well as an improved accuracy of chip position relative to the substrates compared to the accuracy achieved by soldering techniques. Due to the fact that the sintered layers usually are much thinner than standard solder layers, the thermal conductivity is also significantly higher. This results in excellent thermal properties in the sintered connection. Moreover, because the melting point of the silver used in a sintered connection is about four times higher than that of a lead-free solder commonly used nowadays, sintered layers also demonstrate a far higher cycling capability than soldered layers.

Apart from the top connections between the circuit carrier and the power semiconductor, power semiconductor modules further need an electric connection to external electronic components, such as a printed circuit board. These so called input/output (I/O) contacts are usually formed by means of soldered pins or spring contacts, as this is, for instance, shown in DE 10 2004 057421 B4 and DE 100 08572 B4. However, while providing spring contacts leads to a complicated mechanical assembly, the step of soldering contact elements to the circuit carrier leads to an even more complicated assembly process. In particular, solder steps always need additional cleaning and washing steps, which are time consuming and expensive. Furthermore, when assembling the contact pins before the wire bond or ribbon bond connections are made, there exists the problem that the pins are blocking the operation of the bonding machine.

The problem underlying the present invention is to provide a cost-effective way of producing a contact element and a power semiconductor module that have high reliability and current carrying capacity.

This object is solved by the subject matter of the independent claims. Advantageous embodiments are the subject matter of the dependent claims.

The present invention is based on the idea to form the contact element from a sintered contact part and a separate contact pin. The sintered contact part is formed by a protrusion that fits into a receptacle provided at the contact pin. The sintered contact part according to the present invention is sintered to the circuit carrier and the contact pin that later provides the electric connection to an external electronic component, is connected with the sintered contact part only after the wire bond and/or ribbon bond connections have been established. The connection between sintered contact part and contact pin is formed ,according to the invention, via a press-fit connection or a screw fitting instead of soldering.

The advantage of this connection technology can be seen firstly in the fact that a stable mechanical and electrical connection between the circuit carrier and the sintered contact part is established by means of a sinter step that can be performed simultaneously with the sinter step that fixes the chips on the circuit carrier. The sintered contact part can also be placed onto a chip surface and a sintered connection between the chip and the sintered contact part can be established. Due to the fact that the sintered contact part is flat, it does not obstruct the path of the bonding machine. The sintered contact part, in particular, is essentially non-resilient in the axial, as well as in the longitudinal direction. Thereby, pressure can easily be applied for establishing the sinter connection.

A further advantage of the present invention is the fact that the assembly of the sintered contact part can be done with standard die-bonding or SMT (surface mount technology) assembly machines. Also the pin can be attached with commercial available machine. Thus, there is no need for specially designed assembly equipment.

In a configuration which does not form part of the claimed invention, after the bond connections have been attached, the pins which establish a connection to, for instance, a printed circuit board, can be inserted into a receptacle element that forms the sintered contact part. According to said configuration, either a press fit connection or a screw fitting can be provided. Press fit connections can be fabricated in a much more simple way, whereas a screw fitting can be assembled with less mechanical pressure between the two components.

In a configuration which does not form part of the claimed invention, the screw fit can also be formed by a self-tapping screw thread that is arranged at the contact pin.

In a configuration which does not form part of the claimed invention, for the case of a press fit, the contact pin is provided with a cross section that is in at least in one direction larger than the inner cross section of the receptacle element. In particular, the contact pin may have a cross section with a circular, oval, or polygonal shape. Also, any other suitable projections can be provided at the surface of the contact pin for engaging with the inner surface of the receptacle element. Suitable projections can also be arranged at the inner surface of the receptacle element.

According to the claimed invention, the sintered contact part is formed as a sintered protrusion, whereas the contact pin is provided with a receptacle element which is connected to the protrusion via a press-fit connection or a screw fitting. In particular all ideas regarding the fitting of the receptacle element and the contact pin can analogously also be applied to the claimed invention where the receptacle is arranged at the contact pin and where the sintered contact part is a sintered protrusion.

The advantage of using a sintered protrusion instead of a sintered receptacle can be seen in the fact that an even simpler geometric part is to be handled by the sintering process. The receptacle element can be formed preferably as an integral part of the contact pin, for instance by impact extortion or a machining process as this is well-known in the art

According to the invention, for allowing a sintered connection between the protrusion and the circuit carrier, at least the protrusion or both the circuit carrier surface and the protrusion are coated with a sinterable material, such as silver or a silver alloy The sinter paste should suit with the applied material types - as of today Ag, Au and Cu surface working sinter pastes. However, the idea according to the present invention can be used with all sinterable materials that are available.

According to the particular sequence of steps defined in independent method claim 8, the above-mentioned problems with prior art solutions can be overcome, and particularly stable and simple connections to external electronic components can be established.

The accompanying drawings illustrate several examples which do not form part of the claimed invention and an embodiment of the claimed invention. These drawings together with the description serve to explain the principles of the invention. The drawings are merely for the purpose of illustrating how the invention can be made and used, and are not to be construed as limiting the invention.

Further features and advantages will become apparent from the following more particular description of the various drawings, in which like references refer to like elements, and wherein:
- **Fig. 1**: shows a schematic representation of a contact element with a press-fit contact pin;
- **Fig. 2**: shows a contact element with a screwed contact pin;
- **Fig. 3**: shows a cross section of the press-fit contact region within a receptacle element according to a first example;
- **Fig. 4**: shows a cross section of the press-fit contact region within a receptacle element according to a second example;
- **Fig. 5**: shows a cross section of the press-fit contact region within a receptacle element according to a third example;
- **Fig. 6**: shows a cross section of the press-fit contact region within a receptacle element according to a fourth example;
- **Fig. 7**: shows a cross section of the press-fit contact region within a receptacle element according to a fifth example;
- **Fig. 8**: shows a cross section of the press-fit contact region within a receptacle element according to a sixth example;
- **Fig. 9**: shows a cross section of the press-fit contact region within a receptacle element according to a seventh example;
- **Fig. 10**: shows an exemplary view of a power semiconductor module with screwed contact elements;
- **Fig. 11**: shows a flowchart comparing the fabrication of power modules with solder mounted contact elements to the fabrication when using contact elements according to an example which does not form part of the present invention;
- **Fig. 12**: shows an exemplary view of a power semiconductor module with a sintered contact part having more than one receptacle;
- **Fig. 13**: shows an exemplary view of a power semiconductor module with sintered contact parts forming protrusions for being inserted into receptacles of the contact pins according to an embodiment of the present invention;
- **Fig. 14**: is a schematic cross-section through the contact element shown in Figure 13.

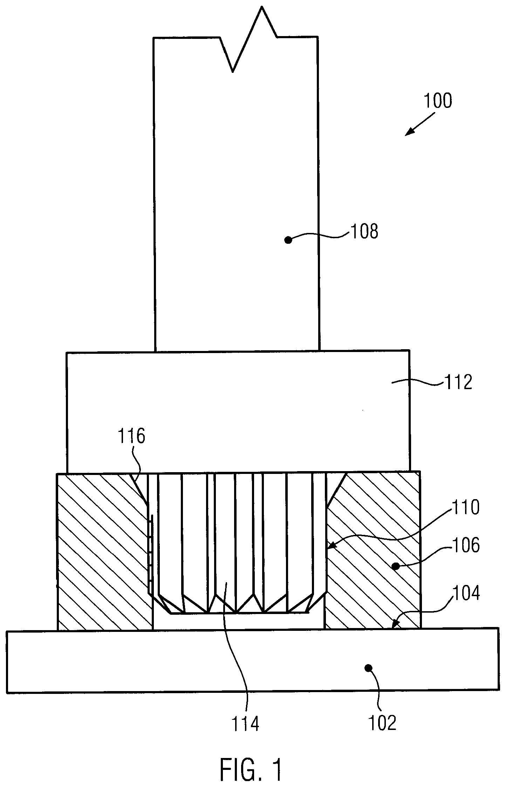

Referring to Fig. 1, a schematic representation of a contact element according to an example, which does not form part of the claimed invention but is useful to understand the claimed invention, is shown.

A contact element 100 is connected to a circuit carrier 102 by means of a sintered connection 104. In order to establish such a sintered connection 104, the contact element 100 is formed as a two-part component: a sintered contact part, in particular a receptacle element 106, and a separate contact pin 108. According to an example, the receptacle element 106 is formed by a rigid, flat, ring-shaped metal part, which can withstand the temperatures and pressure during the sintering step without problems. For forming the complete contact element 100, first the receptacle element 106 is sintered to the circuit carrier 102, and then the contact pin 108 is attached to the receptacle element. According to the example shown in Fig. 1, the contact pin is fixed within the receptacle element 106 by means of an interference press-fit connection 110. A flange shaped protruding collar 112 arranged at the contact pin 108 provides a stop for the insertion of the contact pin and furthermore, ensures the upright positioning of the contact pin within the receptacle element 106. According to the present example, the contact pin 108 is only inserted into the receptacle element 106 after all bond connections of any chips arranged on the circuit carrier 102 have been attached. The relatively flat ring shaped receptacle element 106 does not obstruct the bonding machine's path.

The receptacle element 106 is formed by a ring shaped part, which, according to the example shown in Fig. 1, has a circular cross section for engaging with the star shaped press-fit portion 114 of the contact pin 108. For facilitating the insertion of the press-fit portion 114, the receptacle element 106 has a funnel shaped bezel 116 at its inner surface.

According to the present example, the receptacle element 106 can be coated with a sinterable material, such as silver, a silver alloy, gold and/or copper. Additionally, or alternatively, the footprint area of the circuit carrier 102 whereto the receptacle element 106 is connected can be coated with a sintered material (typically NiAu, NiPdAu, AgPd, AuPd or Ag) applied by means of chemical or physical methods. Advantageously, the sinterable metallization is applied in the form of a paste containing coated particles. The sinter process is a widely used connection technique for connecting power semiconductor components to circuit carriers and involves temperatures of at least 230 °C. Usually, the sintering is performed under ambient air and, in most cases a pressure of about 30 MPa is applied and maintained for at least some seconds during the joining process. There are also sinter silver pastes that do not need pressure, but instead require an extended high temperature period. However, sintered connections without mechanical pressure tend to be more porous and less stable than those which are formed under mechanical pressure. Therefore, it is advantageous that the receptacle element according to the present example can easily be pressed down by means of a standard sinter press.

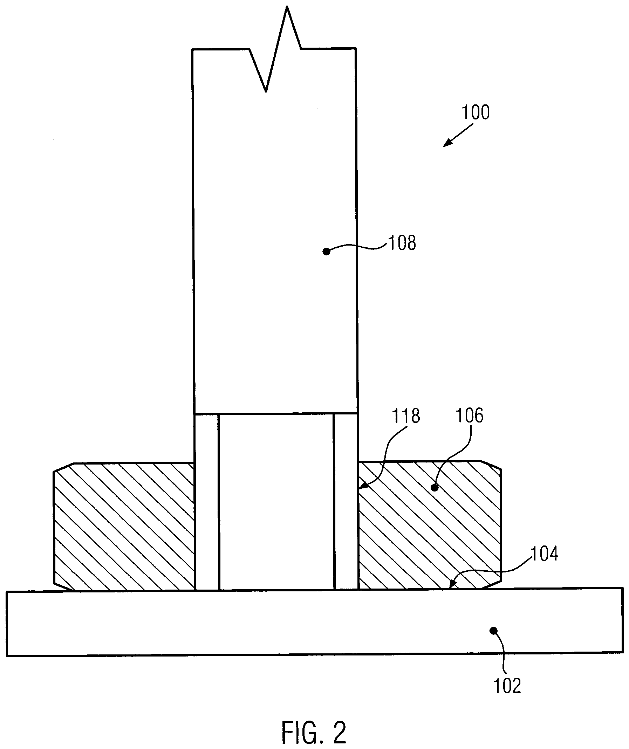

Fig. 2 shows a further example of the contact element 100. According to this example, which does not form part of the claimed invention but is useful to understand the claimed invention, the receptacle element 106 is connected to the contact pin 108 by means of a screw connection 118. Preferably, the receptacle element is provided with a screw thread and the contact pin 108 carries the corresponding thread. However, also a self-tapping mechanism can be used wherein only one of the two partners to be connected carries a screw thread, which cuts its own path in to the other part. The advantage of providing a screw thread, in particular, when fabricating the thread on both parts, can be seen in the fact that no pressure in a longitudinal direction has to be exerted when performing the joining process. On the other hand, the press fit pins can be inserted without requiring a rotating movement of the contact pin 108 during assembly.

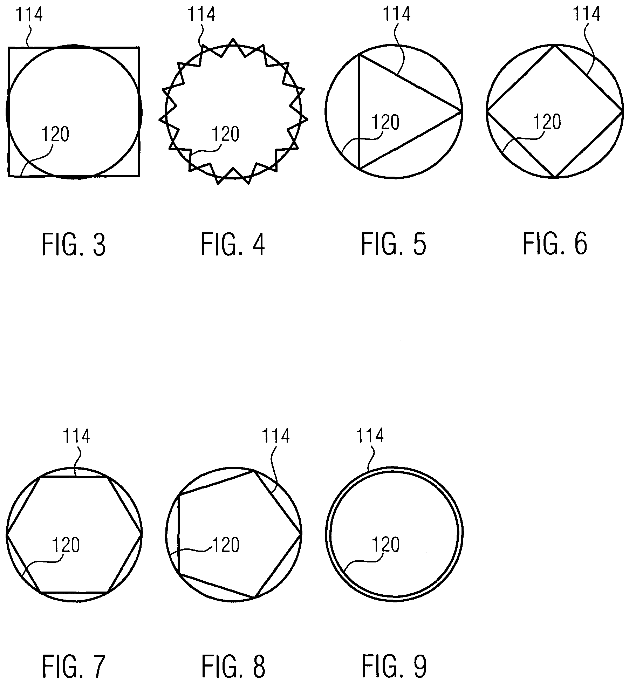

Figs. 3 to 9 illustrate exemplarily several examples how the press fit portion 114 and the matching inner surface 120 of the receptacle element 106 can be formed. In order to establish a press fit connection, the diameter of the press fit portion 114 has to be at least in several regions larger than the inner diameter of the receptacle element. As shown in Fig. 3, this can, for instance, be done by pressing a circular contact pin into a square receptacle. Fig. 4 shows the star shaped press fit portion 114 of Fig. 1, whereas Figs. 5 to 8 illustrate several polygonal cross sections forms of the press fit portion 114 in a circular receptacle. Fig. 9 illustrates the case where a circular press fit portion 114 is inserted into a smaller circular inner surface 120 of the receptacle element.

For a person skilled in the art, however, it is clear that also suitable forms of projections at either the receptacle element or the contact pin or both, leading to an interaction between both partners to be joined, can be used for forming a contact element 100 according to the present invention. Also oblong, in particular oval cross sections can be used for the press-fit portion and/or the receptacle.

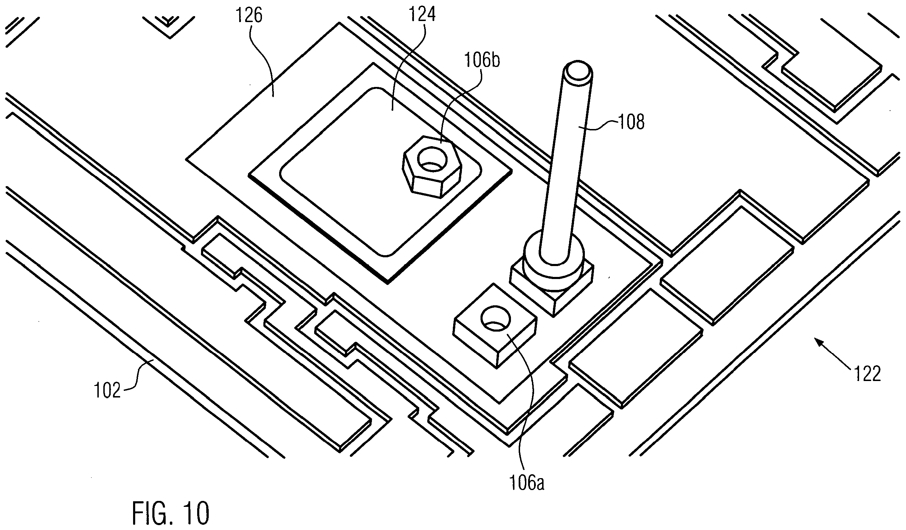

Fig. 10 illustrates in a perspective view an example of a power semiconductor module 122, which has two contact elements according to an example, which does not form part of the claimed invention but is useful to understand the claimed invention. The contact elements 100 are arranged to operate as input/output terminals for a power semiconductor chip 124. The circuit carrier 102 in this particular example is formed by a direct copper bonding structure, which is covered partly by a suitable sinter material 126. As shown in Fig. 10, the contact elements 100 are formed by a receptacle element 106 having a screw thread, and a contact pin 108, which is a standard press-fit contact pin as shown in Fig. 1. The receptacle element (reference numeral 106a) can either be attached to the circuit carrier 102 or to the semiconductor chip 124 (reference numeral 106b).

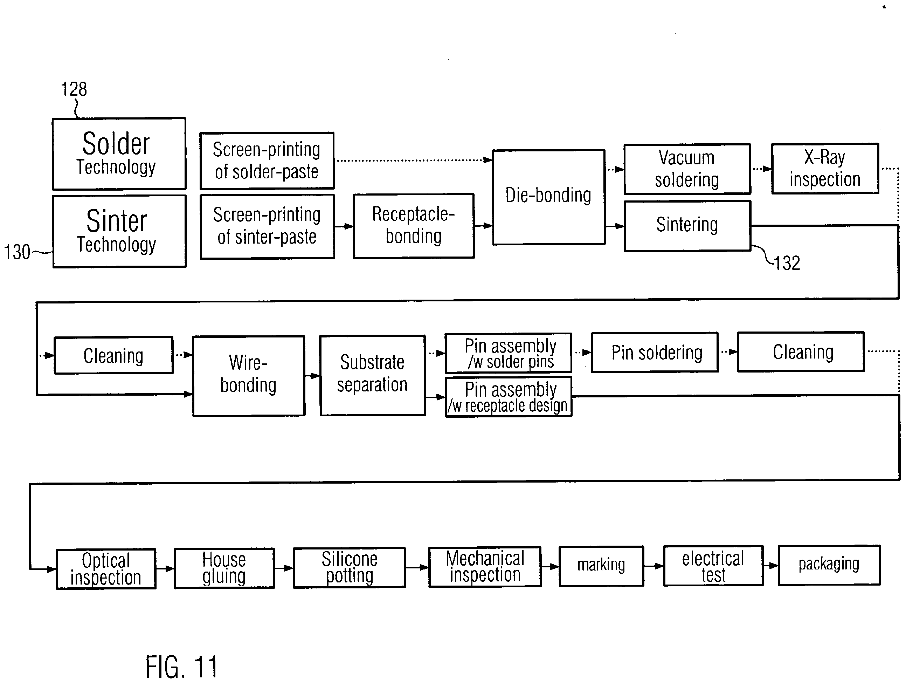

Fig. 11 compares the process sequence 128 for assembling a power semiconductor module when fabricating the contact element with a solder technology to the sequence 130 where the two-part contact element 100 is attached by sintering a receptacle element 106. During the standard process 128 where the pins are put into solder jigs, firstly, solder paste is screen printed and the dies are sintered onto the printed circuit board. In the next step, soldering is performed, and after an X-ray inspection, a cleaning step is necessary to remove the fluxing agents needed for the soldering step.

After cleaning, the die is wire-bonded and the individual substrates are separated. According to the solder process 128, the pins are now assembled into solder jigs and have to be soldered, which is another soldering step that also requires a subsequent time consuming cleaning step. To finalize the production, now an optical inspection takes place. Then the housing is glued and a silicone potting step is performed. After mechanical inspection, marking and an electrical test, the final packaging takes place.

In contrast to the conventional fabrication method 128, the sequence 130 according to an example, which does not form part of the claimed invention but is useful to understand the claimed invention, uses a simultaneous sinter step for joining the chips 124 and the receptacle elements 106 to the circuit carrier 102: Firstly, sinter paste is applied onto the circuit carrier 102 (for example stencil printed, dispensed, laminated, screen printed etc.) and the receptacle elements 106 are aligned on the circuit carrier. Alternatively, an assembly variation where paste is applied on the back side of the chip or the receptacle is also possible. Next, the power semiconductor dies are placed and secured on the circuit carrier. In a simultaneous sintering step 132, both the receptacle elements 106 and the semiconductor chips 124 are joined with the circuit carrier 102.

However, the cleaning step that was necessary with solder technology sequence 128 is no longer needed. The next two steps, the wire bonding of the chips and substrate separation are identical to the sequence 128. The pin assembly is now done by press-fitting or screwing the contact pins 108 into the receptacle elements 106. No soldering step is needed for fixing the pins. Therefore, also the cleaning step following this pin soldering procedure can be omitted. An additional advantage of this sequence of steps is that product versions deviating in pin shape and size can be created at this step without special tooling.

The finalizing steps starting from the optical inspection and ending with a packaging step are the same as for the sequence 128.

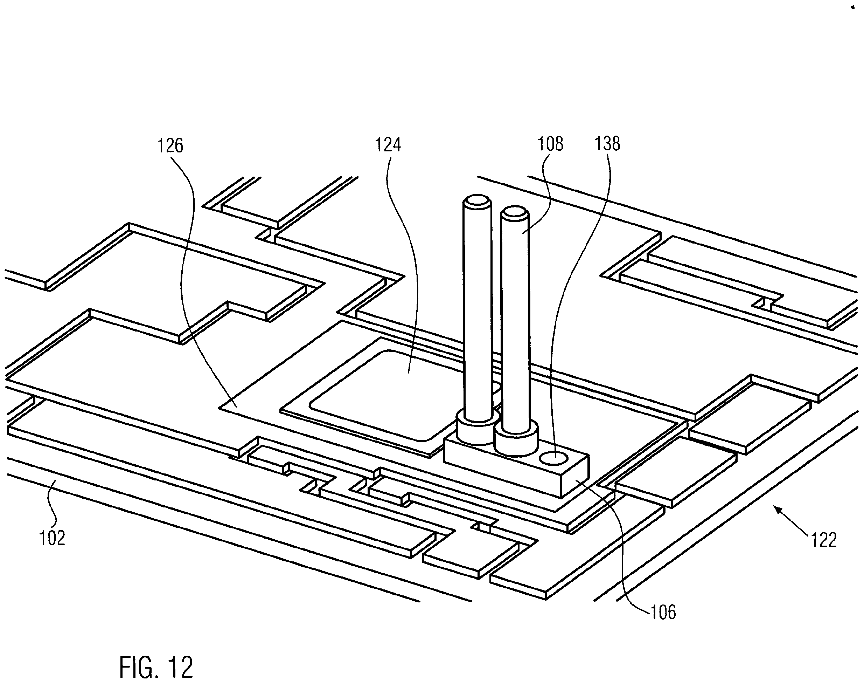

Figure 12 shows another example, which does not form part of the claimed invention but is useful to understand the claimed invention. In particular, according to this example, the sintered contact part 106 is formed to receive in a plurality of openings 138 which all can receive contact pins 108 to be screwed or press-fit therein. In order to allow for an electric insulation between each of the contact pins 108, this multi-receptacle block 106 can be fabricated from an insulating material (for instance ceramics) and can be covered with an electrically conductive material only at the inside of the openings 138 and at particular locations of the underside which is sintered to the centre material 126. However, if only a plurality of interconnected pins on the same potential is needed, the multi-receptacle block 106 may of course also be fully formed from an electrically conductive material. All connection principles shown with respect to Figures 1 to 9 may of course be used for the connection between the contact pin and the belonging receptacle 138.

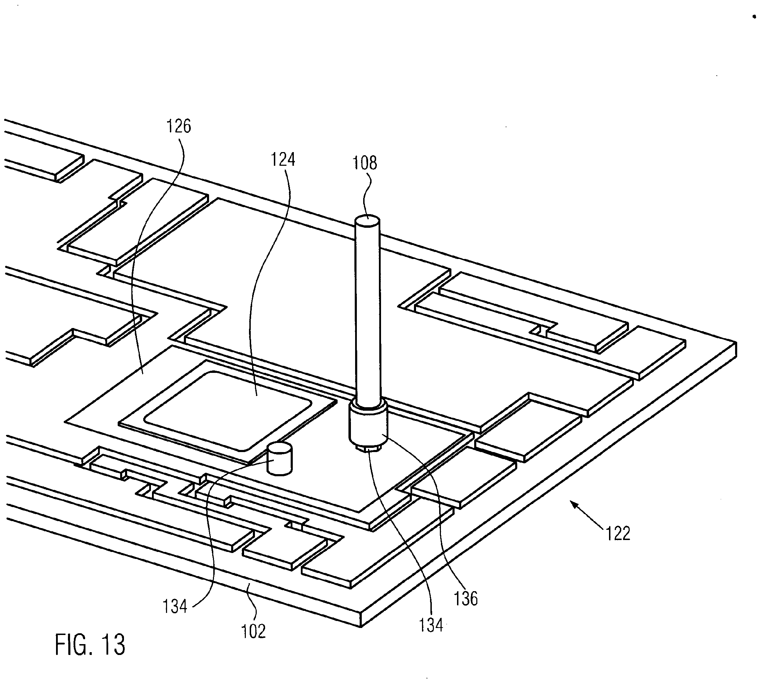

The idea of forming a contact element in a two-part form and using a sintered contact part as one element of the contact element, may be realized according to the claimed j invention by arranging the receptacle at the contact pin 108 which is assembled after the sintered step as this is shown in Figure 13. According to the claimed invention, the sintered contact part is formed by a sintered protrusion 134. These sintered protrusions 134 may be formed in analogy to the forms of the press-fit portion 114 or the screw-thread 118 shown in Figures 1 to 10. The main difference is that the position of the receptacle and the inserted contact part are exchanged in that a sintered protrusion is arranged on the circuit board 102 and a receptacle is formed at the contact pin 108. For some applications, it may be easier to form the receptacle part not as a sintered element but directly at the contact pin 108.

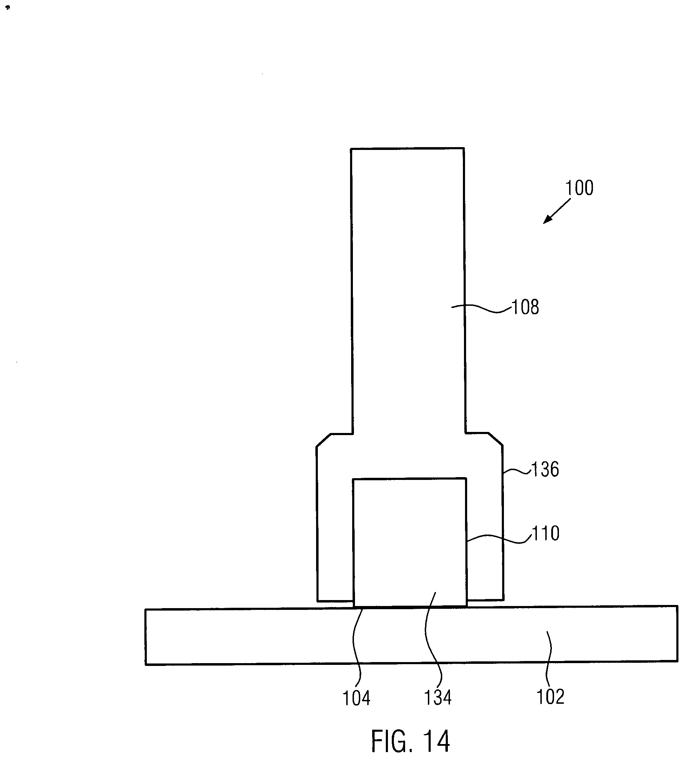

Figure 14 schematically illustrates a cut through the contact element 100 of Figure 13. As may be derived from this figure, the sintered protrusion 134 is fixed to the circuit carrier 102 by means of a sinter connection 104. The contact pin 108 is integrally formed with a receptacle element 136 that is mounted to encompass the sintered protrusion 134 and to form a press-fit connection to or a screw-fitting with the sintered protrusion 134. As already mentioned, all suitable cross-section combinations depicted in figures 1-9 can be applied in the same manner as for the sintered receptacle element 106 interacting with an inserted contact pin 108. In essence this is the inverse design to the previously presented examples. The sintered protrusion can, for instance, be formed by a block of copper and the I/O pins are assembled onto these contact elements by means of the same processes as described above, e.g. press-fit, interference fit or screw nut. The assembly process and the advantages are of course the same as the core design described before. As mentioned above, the design of this contact part can be any of the cross-sections shown in Figures 3-9 with reference numeral 114. The inner design of the pin receptacle may simply be cylindrical or, alternatively, the inner design of the pin receptacle may have a multi-faceted cross-section, whereas the contact block has a simple cylindrical shape.

The multi-receptacle contact part, on the other hand, can handle multiple pins within one body or block, and the number of pins per receptacle is only limited by the size of the circuit carrier.

In summary, the inventive method of assembly is much simpler and faster than assembly methods using standard solder techniques for the contact elements. The chips and the protrusion for forming electrical and mechanical connections are sintered in one simultaneous process step. Energy, process time, cleaning processes and related costs, and clean room footprint requirement can be saved thereby. The chips and the circuit carriers can be bonded before the assembly of the I/O pins. Furthermore, a much more stable and reliable connection between the circuit carrier and the contact element can be provided.

## Claims

1. Contact element (100) for electrically connecting a power semiconductor module (122) to an external electronic component, said power semiconductor module (122) comprising a circuit carrier (102) having at least one conductive lead, and at least one semiconductor element (124), wherein said contact element comprises:
a contact part (134) adapted to be sintered to the circuit carrier (102), thereby being electrically connected to said conductive lead; and
at least one contact pin (108) for contacting to the external electronic component;
wherein said contact part (134) is at least partly covered with a coating facilitating the sinter connection;
**characterized in that**
said contact part (134)
comprises a protrusion (134) adapted to be at least partly inserted into a receptacle element (136) provided at the contact pin (108),
wherein said contact pin (108) and said contact part (134) are formed so as to be fixed to each other via a press-fit connection or a screw fitting.

2. Contact element according to claim 1, wherein said receptacle element (136) has an inner cross-section that has in at least one direction a smaller diameter than the protrusion (134).

3. Contact element according to claim 1 or 2, wherein said contact part (134) is essentially non-resilient in an axial as well as in a longitudinal direction.

4. Contact element according to one of the preceding claims, wherein said receptacle element (136) has an inner surface that is provided with a screw thread (118) or is formed to be self-tapped by a thread arranged at the protrusion (134).

5. Contact element according to one of the preceding claims, wherein said protrusion (134) has a cross-section with a circular, oval, or polygonal shape, or has projections arranged thereon for interacting with an inner surface of the receptacle element (136).

6. Power semiconductor module comprising:
a circuit carrier (102) having at least one conductive lead;
at least one semiconductor element (124) sintered to the circuit carrier;
top side connections formed between the at least one semiconductor element (124) and
the circuit carrier (102); and
at least one contact element (100) according to any one of claims 1 to 5 for electrically connecting said power semiconductor module (122) to an external electronic component, wherein the contact part (134) of the at least one contact element (100) is fixed to the circuit carrier (102) by means of a sinter connection (104), thereby electrically connecting the contact part (134) to said conductive lead.

7. Power semiconductor module according to claim 6, wherein said circuit carrier (102) comprises a ceramic substrate, a direct copper bonding (DCB) circuit carrier, a direct aluminum bonding substrate, or an insulated metal substrate (IMS).

8. Method for fabricating a power semiconductor module (122), the method comprising the following steps:
providing a circuit carrier (102) having at least one conductive lead; and
placing at least one semiconductor element (124) and at least one contact part (134) onto said circuit carrier (102);
the method further comprising the steps of:
coating the contact part (134) with a sinterable coating before placing same on the circuit carrier (102);
performing a sintering step for simultaneously connecting the at least one semiconductor element and the at least one contact part (134) with said circuit carrier (102), thereby electrically connecting the contact part (134) to the conductive lead;
forming top-side connections between said at least one semiconductor element and the circuit carrier (102), after the sintering step; and
fixing, by means of a press-fit connection or a screw fitting, a contact pin (108) with said sintered contact part (134), thereby forming a contact element (100) for contacting to an external electronic component;
wherein the contact pin (108) is provided with a receptacle (136) into which a protrusion (134) forming said sintered contact part is pressed or screwed.

9. Method according to claim 8, wherein providing said circuit carrier (102) comprises the step of applying a sinter material layer on the circuit carrier for facilitating a sintered connection between the contact part (134) and the circuit carrier (102).

10. Method according to claim 9, wherein said sinter material layer comprises NiAu, NiPdAu, AgPd, Au or Ag applied by means of chemical or physical methods.

## Patentansprüche

1. Kontaktelement (100) zum elektrischen Verbinden eines Leistungshalbleiter-Moduls (122) mit einem externen elektronischen Bauteil,
wobei das Leistungshalbleiter-Modul (122) einen Schaltungsträger (102) mit wenigstens einem leitenden Anschluss sowie wenigstens ein Halbleiterelement (124) umfasst und das Kontaktelement umfasst:
ein Kontaktteil (134), das so eingerichtet ist, dass es auf den Schaltungsträger (102) gesintert ist, und dadurch elektrisch mit dem leitenden Anschluss verbunden ist; sowie
wenigstens einen Kontaktstift (108) zum Herstellen von Kontakt mit dem externen elektronischen Bauteil;
wobei
das Kontaktteil (134) wenigstens teilweise mit einer Beschichtung überzogen ist, die die Sinter-Verbindung erleichtert;
**dadurch gekennzeichnet, dass** das Kontaktteil (134) einen Vorsprung (134) umfasst, der so eingerichtet ist, dass er wenigstens teilweise in ein an dem Kontaktstift (108) vorhandenes Aufnahmeelement (136) eingeführt ist,
wobei der Kontaktstift (108) und das Kontaktteil (134) so ausgebildet sind, dass sie über eine Presspass-Verbindung oder eine Schraub-Verbindung aneinander befestigt sind.

2. Kontaktelement nach Anspruch 1, wobei das Aufnahmeelement (136) einen Innenquerschnitt hat, dessen Durchmesser in wenigstens einer Richtung kleiner ist als der Vorsprung (134).

3. Kontaktelement nach Anspruch 1 oder 2, wobei das Kontaktteil (134) sowohl in einer Axial- als auch in einer Längsrichtung im Wesentlichen nicht elastisch ist.

4. Kontaktelement nach einem der vorangehenden Ansprüche, wobei das Aufnahmeelement (136) eine Innenfläche hat, die mit einem Schraubengewinde (118) versehen ist oder so ausgebildet ist, dass sie über ein an dem Vorsprung (134) angeordnetes Gewinde selbstschneidend ist.

5. Kontaktelement nach einem der vorangehenden Ansprüche, wobei der Vorsprung (134) einen Querschnitt mit einer kreisrunden, ovalen oder polygonalen Form hat, oder vorstehende Teile aufweist, die mit einer Innenfläche des Aufnahmeelementes (136) zusammenwirken.

6. Leistungshalbleiter-Modul, das umfasst:
einen Schaltungsträger (102) mit wenigstens einem leitenden Anschluss;
wenigstens ein Halbleiterelement (124), das auf den Schaltungsträger gesintert ist;
Verbindungen der Oberseite, die zwischen dem wenigstens einen Halbleiterelement (124) und dem Schaltungsträger (102) ausgebildet sind; sowie
wenigstens ein Kontaktelement (100) nach einem der Ansprüche 1 bis 5 zum elektrischen Verbinden des Leistungshalbleiter-Moduls (122) mit einem externen elektronischen Bauteil, wobei das Kontaktteil (134) des wenigstens einen Kontaktelementes (100) mittels einer Sinter-Verbindung (104) an dem Schaltungsträger (102) befestigt ist, und
dadurch das Kontaktteil (134) elektrisch mit dem leitenden Anschluss verbunden ist.

7. Leistungshalbleiter-Modul nach Anspruch 6, wobei der Schaltungsträger (102) ein Keramiksubstrat, einen DCB-Schaltungsträger (direct copper bonding circuit carrier), ein DAB-Substrat (direct aluminium bonding substrate) oder ein isoliertes Metallsubstrat (insulated metal substrate - IMS) umfasst.

8. Verfahren zum Herstellen eines Leistungshalbleiter-Moduls (122) wobei das Verfahren die folgenden Schritte umfasst:
Bereitstellen eines Schaltungsträgers (102) mit wenigstens einem leitenden Anschluss; sowie
Positionieren wenigstens eines Halbleiterelementes (124) und wenigstens eines Kontaktteils (134) auf dem Schaltungsträger (102);
wobei das Verfahren des Weiteren die folgenden Schritte umfasst:
Überziehen des Kontaktteils (134) mit einer sinterfähigen Beschichtung vor dem Positionieren auf dem Schaltungsträger (102);
Durchführen eines Sinterschrittes zum gleichzeitigen Verbinden des wenigstens einen Halbleiterelementes und des wenigstens einen Kontaktteils (134) mit dem Schaltungsträger (102), um so das Kontaktteil (134) elektrisch mit dem leitenden Anschluss zu verbinden;
Ausbilden von Verbindungen der Oberseite zwischen dem wenigstens einen Halbleiterelement und dem Schaltungsträger (102) nach dem Sinterschritt; sowie
Befestigen eines Kontaktstiftes (108) an dem gesicherten Kontaktteil (134) mittels einer Presspass-Verbindung oder einer Schrauben-Verbindung, um so ein Kontaktelement (100) zum Herstellen von Kontakt mit einem externen elektronischen Bauteil auszubilden;
wobei der Kontaktstift (108) mit einer Aufnahme (136) versehen ist, in die ein Vorsprung(134) eingepresst oder eingeschraubt wird, der das gesinterte Kontaktteil bildet.

9. Verfahren nach Anspruch 8, wobei Bereitstellen des Schaltungsträgers (102) den Schritt des Aufbringens einer Sintermaterial-Schicht auf den Schaltungsträger zum Erleichtern einer gesinterten Verbindung zwischen dem Kontaktteil (134) und dem Schaltungsträger (102) umfasst.

10. Verfahren nach Anspruch 9, wobei die Sintermaterial-Schicht NiAu, NiPdAu, AgPd, Au oder Ag umfasst, das mittels chemischer oder physikalischer Verfahren aufgebracht wird.

## Revendications

1. Élément de contact (100) pour connecter électriquement un module semi-conducteur de puissance (122) à un composant électronique externe, ledit module semi-conducteur de puissance (122) comprenant un support de circuit (102) comportant au moins un fil conducteur, et au moins un élément semi-conducteur (124), dans lequel ledit élément de contact comprend :
une partie de contact (134) adaptée pour être frittée sur le support de circuit (102), pour être ainsi connectée électriquement audit fil conducteur ; et
au moins une broche de contact (108) pour établir un contact avec le composant électronique externe ;
dans lequel ladite partie de contact (134) est au moins partiellement recouverte par un revêtement qui facilite la connexion frittée ;
**caractérisé en ce que** ladite partie de contact (134) comprend une protubérance (134) adaptée pour être au moins partiellement insérée dans un élément de réceptacle (136) pourvu sur la broche de contact (108),
dans lequel ladite broche de contact (108) et ladite partie de contact (134) sont formées de manière à être fixées entre elles via une connexion par compression ou un assemblage vissé.

2. Élément de contact selon la revendication 1, dans lequel ledit élément de réceptacle (136) présente une section transversale interne ayant un plus petit diamètre que la protubérance (134) dans au moins une direction.

3. Élément de contact selon la revendication 1 ou 2, dans lequel ladite partie de contact (134) est essentiellement non flexible en direction axiale ainsi qu'en direction longitudinale.

4. Élément de contact selon l'une des revendications précédentes, dans lequel ledit élément de réceptacle (136) présente une surface interne qui est pourvue d'un filetage (118) ou est formé pour être autotaraudeur avec un filet agencé sur la protubérance (134).

5. Élément de contact selon l'une des revendications précédentes, dans lequel ladite protubérance (134) présente une section transversale de forme circulaire, ovale ou polygonale, ou comporte des projections agencées pour interagir avec une surface interne de l'élément de réceptacle (136).

6. Module semi-conducteur de puissance comprenant :
un support de circuit (102) comportant au moins un fil conducteur ;
au moins un élément semi-conducteur (124) fritté sur le support de circuit ;
des connexions de face supérieure formées entre ledit au moins un élément semi-conducteur (124) et le support de circuit (102) ; et
au moins un élément de contact (100) selon l'une quelconque des revendications 1 à 5 pour connecter électriquement ledit module semi-conducteur de puissance (122) à un composant électronique externe, dans lequel la partie de contact (134) dudit au moins un élément de contact (100) est fixée au support de circuit (102) au moyen d'une connexion frittée (104), moyennant quoi la partie de contact (134) est connectée électriquement audit fil conducteur.

7. Module semi-conducteur de puissance selon la revendication 6, dans lequel ledit support de circuit (102) comprend un substrat en céramique, un support de circuit à connexion directe en cuivre (DCB), un substrat de connexion directe en aluminium, ou un substrat métallique isolé (IMS) .

8. Procédé de fabrication d'un module semi-conducteur de puissance (122), le procédé comprenant les étapes suivantes :
fourniture d'un support de circuit (102) comportant au moins un fil conducteur ; et
placement d'au moins un élément semi-conducteur (124) et d'au moins une partie de contact (134) sur ledit support de circuit (102) ;
le procédé comprenant en outre les étapes suivantes :
revêtement de la partie de contact (134) avec un revêtement frittable avant de la placer sur le support de circuit (102) ;
mise en œuvre d'une étape de frittage pour connecter simultanément ledit au moins un élément semi-conducteur et ladite au moins une partie de contact (134) audit support de circuit (102), moyennant quoi la partie de contact (134) est connectée électriquement au fil conducteur ;
formation de connexions de face supérieure entre ledit au moins un élément semi-conducteur et le support de circuit (102), après l'étape de frittage ; et
fixation, à l'aide d'une connexion par compression ou d'un assemblage vissé, d'une broche de contact (108) avec ladite partie de contact frittée (134), formant ainsi un élément de contact (100) pour une mise en contact avec un composant électronique externe ;
dans lequel la broche de contact (108) est pourvue d'un réceptacle (136) sur lequel est compressée ou vissée une protubérance (134) formant ladite partie de contact frittée.

9. Procédé selon la revendication 8, dans lequel la fourniture dudit support de circuit (102) comprend l'étape d'application d'une couche de matériau de frittage sur le support de circuit pour faciliter une connexion frittée entre la partie de contact (134) et le support de circuit (102) .

10. Procédé selon la revendication 9, dans lequel ladite couche de matériau de frittage comprend un matériau NiAu, NiPdAu, AgPd, Au ou Ag appliqué au moyen de procédés chimiques ou physiques.
